Europäisches Patentamt

European Patent Office

Office européen des brevets

(11) Publication number: **0 237 342 B1**

## EUROPEAN PATENT SPECIFICATION

(45) Date of publication of patent specification: **11.11.92** (51) Int. Cl.⁵: **H01L 29/78**, G11C 27/04

(21) Application number: **87302110.9**

(22) Date of filing: **11.03.87**

54 **Charge-coupled device.**

(30) Priority: **13.03.86 JP 55885/86**

(43) Date of publication of application:
**16.09.87 Bulletin 87/38**

(45) Publication of the grant of the patent:
**11.11.92 Bulletin 92/46**

(84) Designated Contracting States:
**DE FR GB NL**

(56) References cited:
**GB-A- 2 025 135**
**US-A- 4 538 287**

(73) Proprietor: **SONY CORPORATION**
**7-35 Kitashinagawa 6-chome Shinagawa-ku**
**Tokyo 141(JP)**

(72) Inventor: **Narabu, Tadakuni**
**c/o Sony Corporation 7-35 Kitashinagawa**
**6-chome**
**Shinagawa-ku Tokyo(JP)**
Inventor: **Maki, Yasuhito**
**c/o Sony Corporation 7-35 Kitashinagawa**
**6-chome**
**Shinagawa-ku Tokyo(JP)**

(74) Representative: **Ayers, Martyn Lewis Stanley**
**et al**
**J.A. KEMP & CO. 14 South Square Gray's Inn**
**London, WC1R 5EU(GB)**

Rank Xerox (UK) Business Services

## Description

The present invention relates generally to a semiconductor device for a charge-coupled device. More specifically, the invention relates to a semiconductor device which can convert the charge carriers, which are transferred from a charge transfer means, into signals and output the signals.

A semiconductor device for a charge-coupled device, which is the background art of the present invention, generally comprises a signal inputting portion, a charge transfer means for converting input-signals into charge carriers and transferring the charge carriers, and a signal outputting portion for converting the charge carriers into signals, which are arranged on a semiconductor substrate.

The outputting portion of this semiconductor device includes a p-type silicon substrate connected to ground, a thin n-layer region by n-type ion implantation which is disposed on the upper surface of the p-type silicon substrate, and an insulating layer made of $SiO_2$ which is disposed on the upper surface of the n-layer region. A transfer electrode, an output gate electrode (OG electrode), a floating gate electrode (FG electrode) and a precharge gate electrode (PG electrode) are provided on the upper surface of the insulating layer so as to be laterally disposed. A precharge drain region (PD region) acting as an $n^+$-type diffusion region by n-type ion implantation is also formed on the upper surface of the p-type silicon substrate so as to adjoin the n-layer substrate. By supplying the OG electrode and PG electrode with clock pulses $\phi_{OG}$ and $\phi_{PG}$, each of which has a predetermined period and voltage, electrons transferred to the n-layer region at a location beneath the transfer electrode can be transferred to the n-layer region at a location beneath the FG electrode with a period determied by the clock pulses $\phi_{OG}$ and $\phi_{PG}$ and thereafter can be transferred to the PD region.

Furthermore, a reset-voltage input terminal, to which reset voltage to be supplied to the FG electrode is inputted, is connected to the drain electrode of a field-effect transistor (FET). The source electrode of the FET is connected to the FG electrode and the gate electrode of the FET is connected to a reset-pulse input terminal to which reset pulses $\phi_{FG1}$ are supplied. When the reset pulses $\phi_{FG1}$ supplied to the reset-pulse input terminal are in high-level, the FET is turned on to supply reset-voltage $V_{RS}$ for the FG electrode so as to reset the FG electrode.

In addition, the FG electrode is connected to an output terminal by means of a buffer so that the terminal can obtain output signals according to voltage variation of the FG electrode.

In this type semiconductor device, transferred electrons accumulate in the n-layer region at a location beneath the FG electrode at intervals determined by the clock pulses $\phi_{OG}$ and $\phi_{PG}$ and thereafter the electrons are transferred to the PD region between the clock pulses. According to this device, reset pulses $\phi_{FG1}$ can become high-level when the electrons are transferred to the PD region. When reset pulses $\phi_{FG1}$ is high-level, the FET is turned on to supply reset voltage $V_{RS}$ for the FG electrode so as to reset the FG electrode. On the other hand, when the electrons are transferred to the n-layer region at a location beneath the FG electrode, reset pulses $\phi_{FG}$ can become low-level to allow the FET to be turned off and therefore not to supply reset voltage $V_{RS}$ to the FG electrode so as to supply voltage variation of the FG electrode generated by the electrons, which serves as the output signal, for the output terminal by means of the buffer.

In this type of semiconductor device, the voltage $V_{FG}$ applied to the FG electrode is essentially equal to the reset voltage $V_{RS}$ when the electrons are transferred from the n-layer region at a location beneath the FG electrode to the PD region and the reset voltage $V_{RS}$ is not supplied to the FG electrode while the electrons are transferred. Therefore, the voltage applied to the FG electrode is inversely proportional to charges of the transferred electrons according to the reset voltage $V_{RS}$, i.e. the larger the number of electrons transferred, the lower the voltage $V_{FG}$ appliedto the FG electrode.

However, according to this device, an invertor is required to be connected to the output terminal in order to obtain output signals in response to voltage directly proportional to charges of transferred electrons.

In this semiconductor device, a n-type silicon substrate can be substituted for the p-type silicon substrate and positive holes can be used as transferred charges. In this case, output signals in response to voltage directly proportional to charges of the positive holes can be obtained. However, in order to obtain output signals in response to voltage inversely proportional to charges of the positive holes, it is also required for an invertor to be connected to the output terminal.

US-A-4538287 shows output devices for CCDs with similar constructions and methods of operation to that described above; they suffer from a similar drawback. The preambles of claims 1 and 10 have been based on the disclosures of this specification and the prior art discussed above.

It is therefore a principle object of the present invention to eliminate the aforementioned disadvantage and to provide a semiconductor device in which no inverter is necessary.

The device of the present invention is characterized in that the second means is effective so as in use to output a high level signal to the floating gate electrode when the charge carriers have been transferred to the region beneath the floating gate electrode.

The method of the present invention is characterized by the step of applying a high level voltage to the floating gate electrode when the charge carriers have been transferred to the region beneath the floating gate electrode.

The signal outputting portion can convert the transferred charge carriers into output signals responsive to voltage directly proportional to charges of transferred electrons when the transferred charge carriers are electrons, and inversely proportional to charges of transferred positive holes when the transferred charge carriers are positive holes, without an invertor. The signal outputting portion preferably has a floating gate electrode and means for applying a given voltage at predetermined intevals to the floating gate electrode, and outputs signals by applying a given voltage to the floating gate electrode when said charge carriers are transferred to a location beneath the floating gate electrode. The semiconductor substrate is preferably a p-type silicon substrate, and also can be n-type silicon substrate. In the case of p-type silicon substrate, the signal outputting portion preferably further comprises a thin n-layer region by n-type ion implantation, an insulating layer made of $SiO_2$, a transfer electrode, an output gate electrode, a precharge gate electrode, a precharge drain region acting as a $n^+$-type diffusion region by n-type ion implantation, a field-effect transistor, and a reset pulse input terminal connected to the gate electrode of the field-effect transistor. Shifted reset pulses also can be supplied to the gate electrode so as to be high-level when the charge carriers are transferred to the n-layer region beneath the floating gate electrode, thereby supplying the floating gate electrode with reset voltage to reset the floating gate electrode.

The present invention will be understood more fully from the detailed description given herebelow and from the accompanying drawings of the preferred embodiment of the invention. However, the drawings are not intended to imply limitation of the invention to this specific embodiment, but are for explanation and understanding only.

In the drawings:
Fig. 1 is a schematic diagram of a preferred embodiment of a semiconductor device according to the present invention;
Fig. 2A is a graph of floating gate voltage and reset voltage applied to the semiconductor device in Fig. 1; and
Fig. 2B is a graph of reset pulses supplied to the device in Fig. 1.

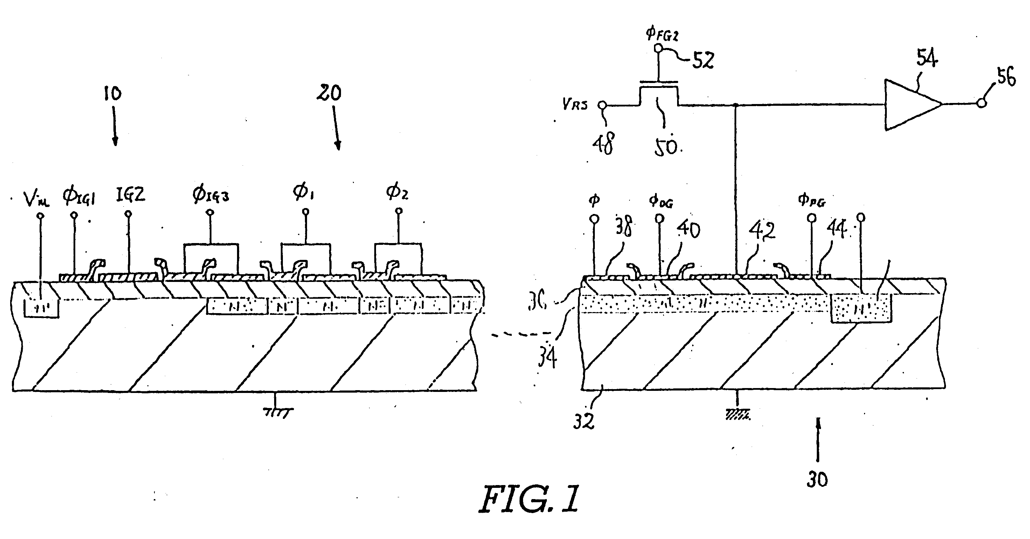

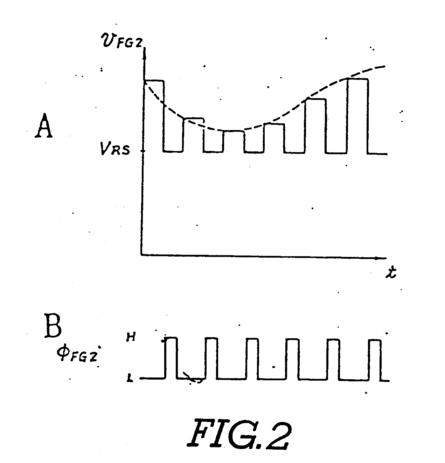

Referring now to the drawings, particularly to Figs. 1 and 2, the preferred embodiment of a semiconductor device, according to the present invention, generally comprises a signal inputting portion 10, a charge transfer means 20 for converting input-signals into charge carriers and transferring the charge carriers, and a signal outputting portion 30 for converting the charge carriers into signals, which are arranged on a semiconductor substrate.

The signal outputting portion of the semiconductor device preferably includes a p-type silicon substrate 32 connected to the earth, a thin n-layer region 34 by n-type ion implantation which is disposed on the upper surface of the p-type silicon substrate 32 and an insulating layer 36 made of $SiO_2$ which is disposed of the upper surface of the n-layer reagion 34. A transfer electrode 38, an OG electrode 40, a FG electrode 42 and a PG electrode 44 are provided on the upper surface of the insulating material 36 so as to be laterally disposed. A PD region 46 which acts as a $n^+$-type diffusion region by n-type ion implantation, is also formed on the upper surface of the p-type silicon substrate 32 so as to adjoin the n-layer substrate. By supplying the OG electrode 40 and PG electrode 44 with clock pulses $\phi_{OG}$ and $\phi_{PG}$, each of which has a predetermined period and voltage, electrons in the n-layer region 34 at a location beneath the transfer electrode 38 can be transferred to the n-layer region 34 at a location beneath the FG electrode 42 at intervals determined by the clock pulses $\phi_{OG}$ and $\phi_{PG}$ and thereafter can be transferred to the PD region 46 within pulse intervals.

Furthermore, a reset voltage input terminal 48, to which reset voltage to be supplied to the FG electrode 42 is inputted, is connected to the drain electrode of a FET 50. The source electrode of the FET 50 is connected to the FG electrode 42 and the gate electrode of the FET 50 is connected to a reset pulse input terminal 52 to which reset pulses $\phi_{FG2}$ are supplied. When the reset pulses $\phi_{FG2}$ supplied to the reset pulse input terminal 52 are in high-level, the FET 50 is turned on to supply the reset voltage $V_{RS}$ for the FG electrode 42 so as to reset the FG electrode 42.

In addition, the FG electrode 42 is connected to an output terminal 56 by means of a buffer 54 so that the output terminal 56 can obtain signals responsive to voltage variation of the FG electrode 42.

In the preferred embodiment of a semiconductior device for charge-coupled devices, according to the present invention, the phase of reset pulses $\phi_{FG2}$ supplied to the gate electrode of the FET 50 is shifted by 180° relative to the phase of the reset pulses $\phi_{FG1}$ of the prior art. When the electrons are transferred at a location beneath the FG electrode 42, the reset pulses $\phi_{FG2}$ are made to be in high-level as opposed to low-level, so that reset voltage $V_{RS}$ is supplied to the FG electrode 42 so as to reset the FG electrode 42.

According to the preferred embodiment of a semiconductor device of the invention, during the transferred electrons be in the n-layer region 34 at a location beneath the FG electrode 42, the reset pulses $\phi_{FG2}$ are at high-level, so that reset voltage $V_{RS}$ is supplied to the FG electrode 42. Therefore, as shown in Figs. 2A and 2B, the voltage $V_{FG}$ of the FG electrode 42 is equal to the reset voltage $V_{RS}$ which the electrons lie in the n-layer region 34 at the location beneath the FG electrode 42. In addition, since electric charges beneath the FG electrode 42 are precharged when the reset pulses $\phi_{FG2}$ change from high-level to low-level, the voltage $V_{FG}$ of the FG electrode 42 is directly proportioned to charges of transferred electrons relative to the reset voltage $V_{RS}$, i.e. the larger the number of electrons transferred, the higher the voltage $V_{FG}$ applied to the FG electrode 42. As a result, output signals in response to the voltage variation applied to the FG electrode 42 can be obtained at the output terminal 56. In addition, by passing through a low-pass filter (not shown), output signals according to voltage variation expressed by the broken line in Fig. 2A can also be obtained.

Therefore, according to the present invention, output signals of a voltage directly proportional to the charges of transferred electrons, can be obtained without an invertor.

In addition, it is also possible to replace a p-type silicon substrate 32 used in the aforementioned preferred embodiment with an n-type silicon substarate and to change the transferred charge carrier into positive holes. In this case, output signals of a voltage inversely proportional to the charge of transferred positive holes, can be obtained without an invertor.

Although the present invention has used so-called bulk charge-coupled device (BCCD) in the aforementioned preferred embodiment of a semiconductor device, a surface channel charge-coupled device (SCCD) or a bucket-brigade device (BBD) may also be used in the semiconductor device.

**Claims**

1. A charge-coupled device comprising:

    an input portion (10) to which signals are inputted;

    first means (20) for converting signals inputted to the input portion into charge carriers and transferring said charge carriers; and

    second means (48, 50, 52) adapted to apply, at regular intervals, a predetermined voltage to a floating gate electrode (42), to a region beneath which the charge carriers are to be transferred by the first means, for converting the charge carriers into output signals.

    characterized in that the second means is operative so as in use to output a high level signal to the floating gate electrode when the charge carriers have been transferred to the region beneath the floating gate electrode.

2. A charge-coupled device according to claim 1, wherein said second means, for converting said charge carriers into output signals, produce a voltage which is a monotonic increasing function of the charge of the transferred electrons in the cases where the transferred charge carriers are electrons, and a monotonic decreasing function of the charge of transferred positive holes in the cases where the transferred charge carriers are positive holes.

3. A charge-coupled device according to claim 2, wherein said input portion 10 and first and second means (20, 48, 50, 52) are provided on a semiconductor substrate (32).

4. A charge-coupled device according to claim 3, wherein said semiconductor substrate is a p-type silicon substrate connected to ground.

5. A charge-coupled device according to claim 4, wherein said second means further comprises a transfer electrode (38), an output gate electrode (40) and a precharge gate electrode (44) disposed on an insulating layer made of $SiO_2$ which is formed on a thin n-layer region (34), a precharge drain region (46) acting as a $n^+$-type diffusion region by n-type ion implantation adjacent the n-layer, a field-effect transistor (50) connected to the floating gate electrode (42), and a reset-pulse input terminal (52) connected to the gate electrode of said field-effect transistor (50).

6. A charge-coupled device according to claim 3, wherein said first means is a bulk channel-coupled device.

7. A charge-coupled device according to claim 3, wherein said first means is a surface channel charge-coupled device.

8. A charge-coupled device according to claim 3, wherein said first means is a bucket-brigade device.

9. A charge-coupled device according to claim 3, wherein said semiconductor device is a n-type silicon substrate.

**10.** A method of outputting signals from a charge-coupled device according to any of the preceding claims comprising:

inputting signals to the charge-coupled device;

converting the signals to charge carriers, and transferring the charge carriers; and

applying a predetermined voltage at regular intervals to a floating gate electrode, to a region beneath which the charge carriers are to be transferred, and converting the charge carriers to output signals.

characterized by the step of applying a high level voltage to the floating gate electrode when the charge carriers have been transferred to the region beneath the floating gate electrode.

**Patentansprüche**

**1.** Ladungsverschiebeanordnung mit

einem Eingangsteil (1), dem Signale eingegeben werden,

ersten Mitteln (20) zum Umwandeln der dem Eingangsteil eingegebenen Signale in Ladungsträger und zum Übertragen der genannten Ladungsträger, und

zweiten Mitteln (48, 50, 52), angewendet zum Anlegen einer vorbestimmten Spannung in regelmäßigen Abständen an eine potentialfreie Gate-Elektrode (42) in einem Bereich, unterhalb dem die Ladungsträger durch die ersten Mittel übertragen werden, zum Umwandeln der Ladungsträger in Ausgangssignale,

dadurch gekennzeichnet, daß die zweiten Mittel derart wirksam sind, daß sie im Betrieb ein Signal mit hohem Pegel an die potentialfreie Steurelektrode anlegen, wenn die Ladungsträger in den Bereich unterhalb der erdfreien Gate-Elektrode übertragen worden sind.

**2.** Ladungsverschiebeanordnung nach Anspruch 1, bei dem die genannten zweiten Mittel zum Umwandeln der genannten Ladungsträger in Ausgangssignale eine Spannung erzeugen, welche eine gleichmäßig ansteigende Funktion der Ladung der übertragenen Elektronen in den Fällen ist, in denen die übertragenen Ladungsträger Elektronen sind, und eine gleichmäßig abfallende Funktion der Ladung der übertragenen positiven Löcher in den Fällen, in denen die übertragenen Ladungsträger positive Löcher sind.

**3.** Ladungsverschiebeanordnung nach Anspruch 2, bei dem der genannte Eingangsteil (10) und die ersten und zweiten Mittel (20, 48, 50, 52) auf einem Halbleitersubstrat (32) angeordnet sind.

**4.** Ladungsverschiebeanordnung nach Anspruch 3, bei dem das genannte Halbleitersubstrat ein mit Masse verbundenes p-Siliziumsubstrat ist.

**5.** Ladungsverschiebeanordnung nach Anspruch 4, bei dem die genannten zweiten Mittel weiterhin eine Übertragungselektrode (38), eine Ausgabe-Gate-Elektrode (40) und eine vorgeladene Gate-Elektrode (44) aufweisen, die auf einer aus SiO2 hergestellten Isolationsschicht angeordnet sind, welche auf einem dünnen n-Schicht-Bereich (34) ausgebildet ist, sowie einen vorgeladenen der n-Schicht benachbarten Drain-Bereich (46), der als ein n+-Diffusionsbereich mit n-Ionenimplantation wirkt, einem mit der potentialfreien Gate-Elektrode (42) verbundenen Feldeffekttransistor (50), und einen mit der Gate-Elektrode des genannten Feldeffekttransistors (50) verbundenen Rücksetzimpuls-Eingangsanschluß (52).

**6.** Ladungsverschiebeanordnung nach Anspruch 3, bei der die genannten ersten Mittel aus einer Bulkkanal-Verschiebeanordnung bestehen.

**7.** Ladungsverschiebeanordnung nach Anspruch 3, bei der die genannten ersten Mittel aus einer Oberflächenkanal-Ladungsverschiebeanordnung bestehen.

**8.** Ladungsverschiebeanordnung nach Anspruch 3, bei der die genannten ersten Mittel aus einer Eimerketten-Anordnung bestehen.

**9.** Ladungsverschiebeanordnung nach Anspruch 3, bei der die genannte Halbleiteranordnung ein n-Siliziumsubstrat aufweist.

**10.** Verfahren der Signalausgabe bei einer Ladungsverschiebeanordnung gemäß einem der vorhergehenden Ansprüche, welches die Schritte aufweist

Eingeben von Signalen in eine Ladungsverschiebeanordnung;

Umwandeln der Signale in Ladungsträger und Übertragen der Ladungsträger; und

Anlegen einer vorbestimmten Spannung in regelmäßigen Abständen an eine potentialfreie Gate-Elektrode in einem Bereich, unterhalb dem die Ladungsträger durch die ersten Mittel übertragen werden, und Umwandeln der Ladungsträger in Ausgangssignale,

gekennzeichnet durch den Schritt, daß eine Spannung mit hohem Pegel an die potentialfreie Gate-Elektrode angelegt wird, wenn die Ladungsträger in den Bereich unterhalb der potentialfreien Gate-Elektrode übertragen worden sind.

**Revendications**

1. Dispositif à couplage de charge comprenant :

une partie d'entrée (10) sur laquelle des signaux sont entrés ;

un premier moyen (20) pour convertir des signaux entrés sur la partie d'entrée en porteurs de charge et pour transférer lesdits porteurs de charge ; et

un second moyen (48, 50, 52) conçu pour appliquer, selon des intervalles réguliers, une tension prédéterminée à une électrode de grille flottante (42), en une région au-dessous de laquelle les porteurs de charge doivent être transférés par le premier moyen, pour convertir les porteurs de charge en signaux de sortie ;

caractérisé en ce que le second moyen peut fonctionner de manière à émettre en sortie, en fonctionnement, un signal de niveau haut pour l'électrode de grille flottante lorsque les porteurs de charge ont été transférés jusqu'à la région qui se situe au-dessous de l'électrode de grille flottante;

2. Dispositif à couplage de charge selon la revendication 1, dans lequel ledit second moyen, pour convertir lesdits porteurs de charge en signaux de sortie, produit une tension qui est une fonction monotone croissante de la charge des électrons transférés dans le cas où les porteurs de charge transférés sont des électrons et qui est une fonction monotone décroissante de la charge des trous positifs transférés dans le cas où les porteurs de charge transférés sont des trous positifs.

3. Dispositif à couplage de charge selon la revendication 2, dans lequel ladite partie d'entrée (10) et lesdits premier et second moyens (20, 48, 50, 52) sont placés sur un substrat semiconducteur (32).

4. Dispositif à couplage de charge selon la revendication 3, dans lequel ledit substrat semiconducteur est un substrat en silicium de type P connecté à la masse.

5. Dispositif à couplage de charge selon la revendication 4, dans lequel ledit second moyen comprend en outre une électrode de transfert (38), une électrode de grille de sortie (40) et une électrode de grille de précharge (44) disposées sur une couche isolante réalisée en SiO₂ qui est formée sur une région de couche mince de type N (34), une région de drain de précharge (46) qui joue un rôle de région de diffusion de type N$^+$ du fait d'une implantation ionique de type N, cette région étant adjacente à la couche de type N, un transistor à effet de champ (50) connecté à l'électrode de grille flottante (42) et une borne d'entrée d'impulsion de remise à l'état initial (52) connectée à l'électrode de grille dudit transistor à effet de champ (50).

6. Dispositif à couplage de charge selon la revendication 3, dans lequel ledit premier moyen est un dispositif à couplage de charge réalisé dans le substrat.

7. Dispositif à couplage de charge selon la revendication 3, dans lequel ledit premier moyen est un dispositif à couplage de charge à canal de surface.

8. Dispositif à couplage de charge selon la revendication 3, dans lequel ledit premier moyen est un dispositif à chapelets.

9. Dispositif à couplage de charge selon la revendication 3, dans lequel ledit dispositif à semiconducteur est un substrat en silicium de type N.

10. Procédé d'émission en sortie de signaux à partir d'un dispositif à couplage de charge selon l'une quelconque des revendications précédentes, comprenant :

l'entrée de signaux sur le dispositif à couplage de charge ;

la conversion des signaux en porteurs de charge et le transfert des porteurs de charge ; et

l'application d'une tension prédéterminée selon des intervalles réguliers à une électrode de grille flottante, en une région au-dessous de laquelle les porteurs de charge doivent être transférés, et la conversion des porteurs de charge en signaux de sortie ;

caractérisé par l'étape d'application d'une tension de niveau haut à l'électrode de grille flottante lorsque les porteurs de charge ont été transférés jusqu'à la région qui se situe au-dessous de l'électrode de grille flottante.

FIG.1

EP 0 237 342 B1

FIG.2